# EUROPÄISCHE PATENTSCHRIFT

(11) **EP 3 324 506 B1**
(45) Veröffentlichungstag und Bekanntmachung des Hinweises auf die Patenterteilung: **21.08.2019**
(21) Anmeldenummer: 16199772.1
(22) Anmeldetag: 21.11.2016
(51) Int. Cl.: H02J 3/00, H02J 13/00, G01R 31/08

(54) **VERFAHREN ZUM AUFBAU EINER DATENBANK ZUR ABBILDUNG DER NETZTOPOLOGIE EINES ELEKTRISCHEN VERTEILNETZES UND VERWENDUNG DIESER DATENBANK**
METHOD FOR ESTABLISHING A DATABASE FOR MAPPING THE NETWORK TOPOLOGY OF AN ELECTRICAL DISTRIBUTION NETWORK AND USE OF THIS DATABASE
PROCÉDÉ DE RÉALISATION D'UNE BASE DE DONNÉES DESTINÉE À REPRÉSENTER LA TOPOLOGIE D'UN RÉSEAU DE DISTRIBUTION ÉLECTRIQUE ET UTILISATION DE LADITE BASE DE DONNÉES

(43) Veröffentlichungstag der Anmeldung: 23.05.2018
(73) Patentinhaber: E.ON SE, 45131 Essen (DE)
(72) Erfinder: Knizia, Malte, 82349 Pentenried (DE); Siepe, Marcus Alexander, 41564 Kaarst (DE)
(74) Vertreter: Glawe, Delfs, Moll

(56) Entgegenhaltungen:
- US-A1- 2004 036 478
- US-A1- 2010 017 214
- US-A1- 2014 012 524
- US-A1- 2014 278 162
- US-A1- 2016 018 458

## Beschreibung

Die Erfindung betrifft ein zweistufiges Verfahren zum Aufbau und zur Aktualisierung einer Datenbank zur Abbildung der Netztopologie eines elektrischen Verteilnetzes, sowie die Verwendung dieser Datenbank zur Lokalisierung von Störungen im Verteilnetz.

Die von Großkraftwerken und dezentralen Energieerzeugern erzeugte elektrische Leistung wird über ein Leitungsnetz zu den Verbrauchern transportiert. Dabei wird die elektrische Leistung zur Überbrückung längerer Distanzen häufig zunächst über Hoch- oder Höchstspannungsnetze geleitet, bevor sie über Mittelspannungsnetze weiter verteilt wird. Bereits an den Mittelspannungsnetzen können einzelne industrielle Verbraucher unmittelbar angeschlossen sein. Der weit überwiegende Teil der Verbraucher, insbesondere Privathaushalte, bezieht elektrische Leistung jedoch über ein den Mittelspannungsnetz nachgelagertes Niederspannungsnetz.

In der Regel verfügen das Hoch- oder Höchstspannungsnetz sowie das Mittelspannungsnetz über Einrichtungen zur Netzüberwachung und werden in einer Leitstelle genau beobachtet, damit Störungen frühzeitig erkannt und ggf. beseitigt werden können. Dabei gestattet es die Netzüberwachung zusammen mit einer detaillierten Kenntnis der Netztopologie, die Position einer Störung im Netz genau zu lokalisieren, um entweder unmittelbar auf den Ort der Störung gerichtete Maßnahmen zur Beseitigung der Störung zu ergreifen oder den Ort der Störung zumindest kurzfristig vom übrigen Netz zu isolieren, damit sich die Störung nicht in andere Bereiche des Netzes fortpflanzt.

In Niederspannungsnetzen ist in der Regel keine derart detaillierte Überwachung vorgesehen. Vielmehr ist der Betreiber eines Niederspannungsverteilnetzes häufig auf die Meldung einer Störung, bspw. eines Stromausfalls, durch Dritte, bspw. Endkunden, angewiesen und kann dann erst mit der Suche nach der Störung beginnen. Dabei ist für den Betreiber im besten Fall bereits aufgrund einer oder mehrere Meldungen ein geographisches Gebiet eingrenzbar, in dem oder in dessen Zuleitung die Störung mit hoher Wahrscheinlichkeit liegt. Eine genaue Zuordnung des wahrscheinlichen Ortes der Störung zur Netztopologie ist jedoch häufig nicht ohne weiteres möglich. Der Betreiber muss daher den tatsächlichen Ort der Störung aufwendig suchen.

Aus dem Stand der Technik sind Verfahren und Anordnungen bekannt, mit denen Störungen in einem Niederspannungsverteilnetz genauer lokalisiert werden können. So schlägt bspw. die europäische Patentanmeldung EP 2 806 572 A1 eine Anordnung vor, bei dem über Kommunikation mit und zwischen an dem Niederspannungsverteilnetz angeschlossene intelligente Stromzähler ("Smartmeter"), die über die Leitungen des Netzes erfolgt, festgestellt werden kann, ob es zu messbaren Signalabschwächungen oder Kommunikationsabbrüchen kommt. Letzteres kann ein Hinweis auf den Ort der Störung liefern, sofern der Betreiber über genaue Informationen betreffend die Netztopologie und die Position der betroffenen intelligenten Stromzähler in dieser Netztopologie verfügt.

Nachteilig an diesem Stand der Technik ist, dass für die Lokalisierung von Störungen in Verteilnetzen zwingend erforderlich besondere Stromzähler, nämlich intelligente Stromzähler, vorgesehen sein müssen. Insbesondere für bereits vorhandene Netze ist der Austausch bereits vorhandener konventioneller Stromzähler mit intelligenten Stromzählern äußerst kostenintensiv und aufwendig. Sofern jedoch nicht sämtliche an das Verteilnetz angeschlossenen Stromzähler intelligente Stromzähler sind, bestehen immer Bereiche, in denen die Lokalisierung einer evtl. Störung nicht möglich ist.

Gattungsgemäße Verfahren sind außerdem aus den Dokumenten US 2010/017214 A1 sowie US 2016/018458 A1 bekannt.

Aufgabe der vorliegenden Erfindung ist es, eine Abbildung der Netztopologie eines Verteilnetzes zu schaffen, auf deren Basis eine Lokalisierung von Störungen in dem Netz möglich ist, ohne dass es dafür einer kostenintensiven Infrastruktur mit besonderen Stromzählern bedarf.

Gelöst wird diese Aufgabe durch ein Verfahren gemäß dem Hauptanspruch sowie der Verwendung gemäß dem nebengeordneten Anspruch. Vorteilhafte Weiterbildungen sind Gegenstand der abhängigen Ansprüche.

Demnach betrifft die Erfindung ein zweistufiges Verfahren zum Aufbau und zur Aktualisierung einer Datenbank zur Abbildung der Netztopologie eines elektrischen Verteilnetzes basierend auf Positionsinformationen über an dem Verteilnetz angeschlossene Geräte, die von einer Empfangseinheit identifizierbare und dem jeweiligen Gerät zuordenbare Funksignale aussenden, mit den bei einem störungsfreien Verteilnetz auszuführenden Schritten:
a) Bestimmen der Position der Empfangseinheit durch ein Positionsbestimmungsmodul der Empfangseinheit und Ermitteln der aktiven, in der Nähe zur Empfangseinheit befindlichen Geräte anhand der von diesen Geräten ausgesendeten identifizierbaren und dem jeweiligen Gerät zuordenbaren Funksignalen;
b) Bestimmen der Position der Geräte, deren Funksignale empfangen wurden; und
c) Ablegen der Identifikationsmerkmale und der Position der Geräte in der Datenbank als neuer Datensatz oder als Aktualisierung eines bestehenden Datensatzes; sowie den im Falle einer Störung im Verteilnetz auszuführenden Schritten:
d) Bestimmen der Position der Empfangseinheit durch ein Positionsbestimmungsmodul der Empfangseinheit;
e) Ermitteln der aktiven, in der Nähe zur Empfangseinheit befindlichen Geräte anhand der von diesen Geräten ausgesendeten identifizierbaren und dem jeweiligen Gerät zuordenbaren Funksignalen;
f) Ermitteln der deaktiven Geräte in der Nähe der Empfangseinheit durch Abgleich der bei einer Störung im Verteilnetz ermittelten aktiven Geräte mit den zuvor bei einem störungsfreien Verteilnetz ermittelten, in der Nähe der Empfangseinheit befindlichen Geräte; und
g) Markieren oder Aktualisieren einer bereits bestehenden Markierung der deaktiven Geräte in der Datenbank als mit hoher Wahrscheinlichkeit zu einem Leistungsstrang gehörig.
Erfindungsgemäß ist auch vorgesehen, dass die Positionsinformationen Angaben zur geographischen Position der Geräte umfassen, und dass die Empfangseinheit als mobiles Endgerät ausgebildet ist.

Die Erfindung betrifft weiterhin die Verwendung einer gemäß dem erfindungsgemäßen Verfahren aufgebauten oder aktualisierten Datenbank zur Lokalisierung von Störungen in einem Verteilnetz mit Hilfe einer Empfangseinheit umfassend ein Positionsbestimmungsmodul, mit den Schritten:
a) Ermitteln der aktiven, in der Nähe zur Empfangseinheit befindlichen Geräte anhand der von diesen Geräten ausgesendeten identifizierbaren und dem jeweiligen Gerät zuordenbaren Funksignale;
b) Bestimmen der Position der Empfangseinheit durch das Positionsbestimmungsmodul;
c) Ermitteln von in der Nähe der Empfangseinheit befindlichen Geräte aus der Datenbank auf Basis der ermittelten Position der Empfangseinheit;
d) Ermitteln der deaktiven Geräte in der Nähe der Empfangseinheit durch Abgleich der ermittelten aktiven Geräte mit den ermittelten in der Nähe der Empfangseinheit befindlichen Geräte; und
e) Eingrenzen der Störung im Verteilnetz durch Auswertung der Positionsinformationen der ermittelten aktiven und deaktiven Geräte.

Zunächst werden einige in Zusammenhang mit der Erfindung verwendete Begriffe näher erläutert:
Von Geräten ausgesendete Funksignale sind im Sinne der Erfindung "identifizierbar und dem jeweiligen Gerät zuordenbar", wenn sich aus einem empfangenen Funksignal wenigstens ein unterscheidbares Identifikationsmerkmal ableiten lässt, welches sich zur Zuordnung des Funksignals zu einem einzelnen Gerät als eindeutige Quelle eignet. So weisen bspw. von Sendern für digitale Funknetze (bspw. ein "Wireless Local Area Network", WLAN) wiederholend ausgesendeten Funksignale zur Identifikation ("Beacons") neben einer Kennung des Netzes ("Service Set Identifier", SSID) regelmäßig auch eine den Sender bzw. das Gerät identifizierende Kennung ("Media-Access-Control"-Adressen, MAC-Adresse) auf, sodass bei Empfang des Funksignals eindeutig ein Gerät als Sender identifiziert werden kann. Vergleichbares gilt für die Signale anderer Funknetze, insbesondere digitaler Funknetze.

Ein Gerät gilt als "aktiv", wenn es Funksignale aussendet, die grundsätzlich von der Empfangseinheit empfangen werden können sowie identifizierbar und einem Gerät zuordenbar sind. Ein Gerät gilt dann als "deaktiv", wenn es zwar grundsätzlich geeignet ist, entsprechende Funksignale auszusenden, um als aktives Gerät im Sinne der Erfindung zu gelten, zu einem fraglichen Zeitpunkt aber keine Funksignale aussendet. Vorrichtungen, die keine Funksignale aussenden können, die grundsätzlich identifizierbar und zuordenbar sind, sind keine "Geräte" im Sinne der Erfindung. Typische Geräte im Sinne der Erfindung sind bspw. WLAN-Router, intelligente Haushaltsgeräte, vernetzte Fernseher oder drahtlose Drucker.

Ein Netz gilt als "störungsfrei" im Sinne der Erfindung, wenn zumindest der die Empfangseinheit umgebene Bereich des Netzes störungsfrei ist, sodass keines von der Empfangseinheit als ggf. deaktiv identifiziertes Gerät aufgrund einer Störung im Netz deaktiv ist.

Die Erfindung hat erkannt, dass sich die Funksignale, die regelmäßig in großer Zahl von an dem Verteilnetz durch Nutzer angeschlossene Geräte ausgesendet werden, bei entsprechender Aufbereitung zur Lokalisierung von Störungen im Verteilnetz nutzen lassen. Dabei wird sich der Umstand zunutze gemacht, dass entsprechende Geräte bei Wegfall der Stromversorgung in der Regel keine Funksignale mehr aussenden, sodass ein Ausbleiben von Funksignalen entsprechender Geräte ein Anzeichen für eine Störung im Verteilnetz darstellen kann. Damit entsprechende Rückschlüsse möglich sind, ist es jedoch erforderlich, Informationen über diese Geräte in geeigneter Form zu erfassen und auf diese bei Bedarf zurückgreifen zu können.

Die Erfindung betrifft daher ein Verfahren, mit dem die Informationen über grundsätzlich am Verteilnetz angeschlossene Geräte in geeigneter Form aufbereitet werden, um im Falle einer späteren Störung im Verteilnetz die Störung lokalisieren zu können. Dabei kann es sich bei der Störung im Verteilnetz in erster Linie um einen Stromausfall, der durch eine Fehlfunktion im Verteilnetz selbst hervorgerufen wird, handeln. Mit den durch das erfindungsgemäße Verfahren aufbereiteten Informationen ist es aber auch grundsätzlich möglich, nachgelagerte Störungen, bspw. das Herausspringen einer Sicherung in einer Hausverteilung, zu identifizieren, womit gleichzeitig eine vermeintliche Störung im Verteilnetz ausgeschlossen werden kann.

In einer ersten Stufe des erfindungsgemäßen Verfahrens werden zunächst die Position einer Empfangseinheit bestimmt und die sich in deren Nähe befindlichen aktiven Geräte ermittelt.

Bei der Empfangseinheit handelt es sich um ein mobiles Endgerät, wie bspw. ein Smartphone oder Tablet. Insbesondere kann es sich um ein mobiles Endgerät eines Nutzers handelt, der das Endgerät z.B. nutzt, um den Zählerstand seines Stromzählers elektronisch auszulesen oder ein Foto des Zählerdisplays macht, um den Zählerstand oder das Foto anschließend an den Betreiber des Versorgungsnetzes zu übermitteln. Alternativ können Zählerstand und eine Zähleridentifikationsnummer auch manuell von dem Nutzer eingegeben und anschließend an den Betreiber des Versorgungsnetzes übermittelt werden. Es ist aber auch möglich, dass die Empfangseinheit ein stationäres und/oder unmittelbar mit dem Versorgungsnetz verbundenes Gerät ist.

Zur Bestimmung der Position der Empfangseinheit sind im Stand der Technik diverse Methoden bekannt. Neben der Positionsbestimmung über Satellitennavigation (bspw. GPS, GLONASS oder GALILEO), ist es auch möglich, die Position der Empfangseinheit anhand der von Geräten empfangenen Funksignale zu bestimmen, bspw. durch WLAN-basierte Ortung oder GSM-Ortung. Die Funksignale können dabei grundsätzlich auch von den Geräten stammen, die anschließend oder gleichzeitig als in der Nähe befindliche Geräte ermittelt werden. Ist eine momentane Positionsbestimmung nicht möglich, kann auch auf die zuletzt ermittelte Position der Empfangseinheit zurückgegriffen werden. Bei mobilen Empfangseinheiten wird jedoch vorzugsweise nur dann auf abgespeicherte Positionen zurückgegriffen, wenn die zugrundeliegende Ermittlung dieser Position nicht länger als 10 Minuten, vorzugsweise nicht länger als 5 Minuten zurückliegt.

Die Ermittlung der aktiven, in der Nähe zur Empfangseinheit befindlichen Geräte umfasst den Empfang von diesen ausgesendeter identifizierbaren und dem jeweiligen Geräte zuordenbaren Funksignalen. In anderen Worten wird durch die Empfangseinheit überprüft, welche identifizierbaren Funksignale empfangen werden können. Werden Funksignale von einem bestimmten Gerät durch die Empfangseinheit empfangen, gilt das Gerät als in der Nähe zur Empfangseinheit befindlich. Aufgrund der je nach Art der Funksignale typischen Reichweite kann "die Nähe zur Empfangseinheit" bei unterschiedlichen Signalarten unterschiedlich definiert sein.

Anschließend wird die Position der Geräte, deren Funksignale von der Empfangseinheit empfangen wurden, ermittelt. Dazu kann - je nach Art des empfangenen Funksignals - auf bereits bestehende Verzeichnisse von Ortsangaben für entsprechende Geräte zurückgegriffen werden, wie bspw. auf Verzeichnisse georteter WLAN-Zugangspunkte mit Zuordnung anhand der MAC-Adressen und/oder SSIDs der Zugangspunkte, oder auf Verzeichnisse von GSM-Mobilfunkmasten mit Zuordnung über deren Cell-ID. Es ist aber auch möglich, dass die von der Empfangseinheit empfangenen identifizierbaren Funksignale bereits unmittelbare Informationen über die Position des jeweils aussendenden Geräts enthalten, bspw. weil dieses über einen GPS-Empfänger verfügt oder es sich um ein stationäres Gerät handelt, dessen Position im Gerät selbst eingespeichert ist. Insbesondere wenn sich die Position eines Gerätes nicht auf andere Weise ermitteln lässt, kann als Position des Gerätes näherungsweise zunächst auch die Position der Empfangseinheit angenommen werden, wobei als maximaler Abstand zwischen der Position der Empfangseinheit und der tatsächlichen Position des Gerätes die typische maximale Reichweite der Art der von dem Gerät ausgesendeten Funksignale angenommen werden kann (bei handelsüblichen WLAN-Routern bspw. 30 bis 100 m, bei Bluetooth-Geräten je nach Klasse 1m, 10m oder 100m).

Die vorstehend erwähnten Positionen und Positionsinformationen umfassen geografische Positionen bzw. Positionsinformationen. Weiter vorzugsweise werden die Positionsinformationen als Positionsbereiche hinterlegt. Ist eine Position als Positionsbereich hinterlegt, ist die genaue Position des Geräts im Regelfall zwar nicht bekannt, befindet sich aber innerhalb des jeweiligen Positionsbereichs. Dabei können die Positionsbereiche als Umkreis um eine zentrale Position oder als Polygonzug definiert sein.

Die so gewonnenen Informationen über die in der Nähe der Empfangseinheit befindlichen Geräte und ihre Position werden abschließend in einer Datenbank abgelegt. Ist für eines der Geräte bereits ein Eintrag in der Datenbank vorhanden, kann dieser Datensatz bei Bedarf durch die neu ermittelten Informationen aktualisiert werden.

Wird bspw. die Position eines an sich bereits bekannten Gerätes, für welches zunächst nur ein erster Positionsbereich definiert und in der Datenbank hinterlegt werden konnte, ein weiteres Mal von derselben oder einer anderen Empfangseinheit ermittelt, wobei ein von dem vormals ermittelten ersten Positionsbereich abweichender zweiter Positionsbereich bestimmt werden kann, kann der in der Datenbank letztendlich der Überschneidungsbereich des ersten und zweiten Positionsbereich als Positionsbereich hinterlegt werden. Es kommt also zu einer Aktualisierung des Datensatzes des betroffenen Gerätes und letztendlich zu einer Präzisierung der Positionsinformation bzw. des Positionsbereiches dieses Gerätes.

Es ist bevorzugt, wenn - soweit möglich - in der Datenbank für die einzelnen Geräte Informationen über den wahrscheinlichen Netzanschlusspunkt, über den das jeweilige Gerät mit Energie versorgt wird, hinterlegt wird. Handelt es sich bei der Empfangseinheit bspw. um ein mobiles Endgerät eines Nutzers, welches dazu verwendet wird, um einen Zählerstand eines Stromzählers zu übermitteln, können die in dem mobilen Endgerät hinterlegten Zugangsdaten zur Identifikation von wahrscheinlich über diesen Stromzähler mit Energie versorgten Geräte herangezogen werden. Erfasst ein Nutzer nämlich den Zählerstand eines Stromzählers mit dem Endgerät - bspw. elektronisch oder als Foto - ist davon auszugehen, dass sämtliche Geräte in der Nähe zu dem im Endgerät Zugangsdaten hinterlegt sind, eben diesem Nutzer zuzuordnen sind, weshalb in der Folge weiterhin davon auszugehen ist, dass diese Geräte über den Stromzähler dieses Nutzers mit Energie versorgt werden. Gleiches kann auch für Geräte angenommen werden, mit denen die Empfangseinheit zum Zeitpunkt der Erfassung des Zählerstandes aktiv - bspw. per WLAN oder Bluetooth - verbunden ist.

Indem die beschriebene erste Stufe des erfindungsgemäßen Verfahrens mehrfach durchlaufen wird - bspw. da eine Vielzahl von Kunden mit ihren Smartphones den Zählerstand Ihres Stromzählers elektronisch oder in Form eines Fotos des Zählerdisplays übermitteln, ergibt sich eine umfassende Datenbank mit Positionsangaben zu Geräten, wobei davon auszugehen ist, dass zumindest ein Großteil der Geräte über das Versorgungsnetz mit elektrischer Energie versorgt wird. Es ist auch möglich, dass der Netzbetreiber selbst eine oder mehrere mobile oder stationäre Empfangseinheiten betreibt, mit denen die Datenbank wie beschrieben aufgebaut und aktuell gehalten werden kann.

Für die zweite Stufe des Verfahrens muss eine Störung im Netz vorliegen. Dabei kann es sich um eine unvorhergesehene Störung - bspw. einen Kurzschluss oder ein Beschädigung einer Leitung - oder um eine geplante Störung - bspw. dem Abschalten eines Leitungsstrangs wegen Wartungsarbeiten oder Abschalten eines Teilnetzes aufgrund von Stromengpässen - handeln. Insbesondere in den erstgenannten Fällen ist damit zu rechnen, dass Nutzer beim Netzbetreiber eine Störung melden. Erfolgt dies über ein mobiles Endgerät, wie bspw. ein Smartphone, können die nachfolgend beschriebenen Schritte unmittelbar durchgeführt werden. Alternativ ist es möglich, dass im Gebiet der Störung bereits eine (bspw. stationäre) Empfangseinheit des Netzbetreibers vorhanden ist, oder der Netzbetreiber vor dem Beheben der Störung eine entsprechende Empfangseinheit in das betroffene Gebiet einbringt. Auch so ist die Durchführung der nachfolgenden Schritte möglich.

Im Falle einer Störung im Verteilnetz wird zunächst wieder die Position der Empfangseinheit bestimmt und die aktiven in der Nähe zur Empfangseinheit befindlichen Geräte ermittelt. Dieser Schritt entspricht dem bereits beschriebenen Schritt bei störungsfreiem Verteilnetz, weshalb auf die diesbezüglichen Ausführungen verwiesen wird.

Anschließend werden die deaktiven Geräte in der Nähe der Empfangseinheit durch Abgleich der bei der Störung im Verteilnetz ermittelten aktiven Geräte mit den zuvor bei einem störungsfreien Verteilnetz ermittelten, in der Nähe der Empfangseinheit befindlichen Geräte ermittelt. In anderen Worten wird überprüft, von welchen Geräten bei einem störungsfreien Netz von der Empfangseinheit eigentlich Funksignale empfangen werden müssten. Dies lässt sich anhand der Position der Empfangseinheit ohne weiteres aus der in der ersten Stufe des Verfahrens aufgebauten und/oder aktualisierten Datenbank auslesen.

Diejenigen Geräte, die als deaktiv identifiziert wurden, können anschließend in der Datenbank als mit hoher Wahrscheinlichkeit zu einem Teilbereich des Versorgungsnetzes oder eines Leitungsstrang - nämlich zu einem von der Störung betroffenen Teilbereich bzw. Leitungsstrang - gehörig markiert werden. Besteht in der Datenbank eine entsprechende Markierung für ein betroffenes Gerät bereits, kann diese, sofern erforderlich, aktualisiert werden.

Die Zuverlässigkeit der Daten in der Datenbank erhöhen sich mit jeder Störung im Verteilnetz, bei der Daten gemäß der zweiten Stufe des erfindungsgemäßen Verfahrens gewonnen werden. Eine so erstellte Datenbank ermöglicht es bei weiteren Störungen im Netz, bei der die Datenbank nicht ausschließlich aktualisiert wird, die wenigstens räumliche Eingrenzung einer Störung und/oder eine Abschätzung über die Größe einer Störung. Hierzu werden die deaktiven Geräte über eine oder mehrere Empfangseinheiten, deren Position jeweils bestimmbar ist, ermittelt, womit sich anhand der in der Datenbank hinterlegten Positionsinformationen zu diesen Geräten und/oder die Zugehörigkeit zu einem bestimmten Netzanschlusspunkt der Ort einer Störung bereits eingrenzen lässt. Die letztendliche Suche nach dem Ort der Störung kann so deutlich erleichtert werden, wenn die wahrscheinliche Region der Störung im Verteilnetz anhand der erfindungsgemäß erzeugten Datenbank ermittelt werden kann.

Für die vorbeschriebene zweite Stufe des Verfahrens ist es grundsätzlich ausreichend, wenn ermittelt wird, welche Geräte im gleichen Teilbereich des Verteilnetzes oder an einem gemeinsamen Leitungsstrang hängen. Es kann für das Auffinden und Beheben einer Störung im Verteilnetz jedoch hilfreich sein, wenn der fragliche Leitungsstrang mit einer ausreichenden Wahrscheinlichkeit identifiziert wird. Hierzu ist es möglich, anhand der Planungs- und Dokumentationsunterlagen des Leitungsverlaufs des Verteilnetzes und der Positionsinformationen der fraglichen Geräte zu ermitteln, mit welchem Leistungsstrang die einzelnen Geräte vermutlich verbunden sind, und geeignete Identifizierungsmerkmale des Leistungsstrang (bspw. interne Bezeichnung des Netzbetreibers) in der Datenbank zu den betroffenen Geräten zu ergänzen. Ist der Netzanschlusspunkt, über den ein Gerät wahrscheinlich mit Energie versorgt wird (siehe oben), lässt sich anhand der Planungs- und Dokumentationsunterlagen der dazugehörige Leitungsstrang ermitteln. Anhand der Planungs- und Dokumentationsunterlagen lassen sich durch Abgleich mit der Datenbank außerdem Bereiche der Netztopologie ermitteln, in denen keine oder nur wenig Geräte erfasst sind. Der Netzbetreiber kann diese Bereiche dann bei Bedarf auf andere Weise überwachen.

Alternativ oder zusätzlich können Identifizierungsmerkmale des fraglichen Leitungsstrangs oder einer Gruppe von Leitungssträngen nach Beheben der Störung im Verteilnetz hinzugefügt werden. Im Falle einer unvorhergesehenen Störung, muss diese zunächst regelmäßig lokalisiert werden. Eine erfolgte Lokalisierung der Störung lässt dann allerdings Rückschlüsse zu, mit welchem Leitungsstrang - oder falls die Störung an einem vorgelagerten Verteilerknoten auftritt, welchen Leitungssträngen - die als deaktiv ermittelten Geräte mit hoher Wahrscheinlichkeit verbunden sind. Diese Information zu den von der Störung betroffenen Leitungssträngen kann in die Datensätze der von der Störung betroffenen Geräte aufgenommen werden. Für eine geplante Unterbrechung einzelner oder mehrerer Leistungsstränge gilt dies analog.

Neben den Positionsinformationen können in der Datenbank noch weitere Informationen über die einzelnen Geräte hinterlegt sein. Beispielsweise sind Geräte bekannt, die nur zu bestimmten Zeiten bzw. in bestimmten Zeiträumen Funksignale aussenden. Ein typisches Beispiel hierfür sind WLAN-Zugangspunkte in öffentlichen Einrichtungen, die bspw. nur während der jeweiligen Öffnungszeiten aktiv sind. Um zu gewährleisten, dass ein entsprechendes, nur zeitweise aktives und im erfindungsgemäßen Verfahren als deaktiv ermitteltes Gerät fälschlicherweise als aufgrund einer Netzstörung deaktives Gerät identifiziert wird, obwohl es lediglich aufgrund eines vorgegebenen Zeitplans deaktiviert wurde, kann die Datenbank Informationen über die zeitabhängige Aktivierung und Deaktivierung von wenigstens einem Teil der an dem Verteilnetz angeschlossenen Geräte enthalten. So können nur zeitweise aktive Geräte ordnungsgemäß bei der Abbildung der Netztopologie berücksichtigt werden.

Es ist auch möglich, dass die Datenbank noch Informationen darüber enthält, ob an das Verteilnetz angeschlossene Geräte über eine unterbrechungsfreie Stromversorgung (USV) verfügen. Entsprechende Geräte mit USV senden grundsätzlich auch bei einer Störung im Netz und bspw. dem Wegfall der Versorgung mit elektrischer Leistung über das Verteilnetz zumindest noch über einen gewissen Zeitraum Funksignale aus, die von der Empfangseinheit als Hinweis auf ein aktives Gerät aufgefasst werden. Um zu vermeiden, dass entsprechende Geräte im Zweifelsfalls einem Leitungsstrang zugeordnet werden, an den diese tatsächlich nicht angebunden sind, kann eine entsprechende Information in der Datenbank aufgenommen werden, um Geräte mit unterbrechungsfreier Stromversorgung bei der Abbildung der Netztopologie ggf. auszunehmen. Da die Funksignale der Geräte regelmäßig Informationen über das Gerät selbst - wie bspw. eine eindeutige Produktbezeichnung oder Produktnummer - enthalten, können die Informationen über eine evtl. USV aus einer geeigneten Produktdatenbank anhand dieser Informationen gewonnen werden. Wird festgestellt, dass ein oder mehrere Geräte in einem von einer Störung betroffenen Teil des Verteilnetzes zumindest für einen gewissen Zeitraum noch weiter Signale aussenden, wobei aufgrund der Größe der Störung höchstwahrscheinlich auch die Stromversorgung der fraglichen Geräte unterbrochen ist, kann davon ausgegangen werden, dass diese Geräte über eine unterbrechungsfreie Stromversorgung verfügen. Entsprechend kann dies in der Datenbank vermerkt werden. Wird für mehrere Geräte desselben, identifizierbaren Typs festgestellt, dass diese höchstwahrscheinlich über eine unterbrechungsfreie Stromversorgung verfügen, kann diese gerätespezifische Information auch in der Produktdatenbank abgelegt werden. Wird nun ein neues Gerät des fraglichen Typs erkannt und in die Datenbank aufgenommen, kann dieses Gerät als mit einer USV ausgestattet verzeichnet werden.

Vorzugsweise sind die von der Empfangseinheit identifizierbaren und einem Gerät zuordenbare Funksignale WLAN-, Bluetooth-, Zigbee-, Z-Wave- und/oder EnOcean-Signale.

Das gemäß dem erfindungsgemäßen Verfahren erzeugte Abbild der Netztopologie kann zur Lokalisierung von Störungen im Netz genutzt werden. Werden bei einer Störung durch eine Empfangseinheit ein oder mehrere Geräte als deaktiv identifiziert, deren Position und/oder Anbindung an einen Leitungsstrang in der Datenbank hinterlegt sind, kann anhand des oder der deaktiven Geräte auf die von der Störung betroffenen Leitungsstränge und somit auf den Ort der Störung geschlossen werden. Eben dies ist Gegenstand der erfindungsgemäßen Verwendung. Zur Erläuterung der einzelnen Schritte der Verwendung wird auf die vorstehenden Ausführungen zu vergleichbaren Schritten des erfindungsgemäßen Verfahrens verwiesen.

Die Erfindung wird nun anhand eines Ausführungsbeispiels unter Bezugnahme auf die beigefügten Zeichnungen weiter beschrieben. Es zeigen:
- Figur 1:: eine Anordnung zur Durchführung des erfindungsgemäßen Verfahrens bei störungsfreiem Verteilnetz; und
- Figur 2:: die Anordnung aus Figur 1 bei einer Störung im Verteilnetz.

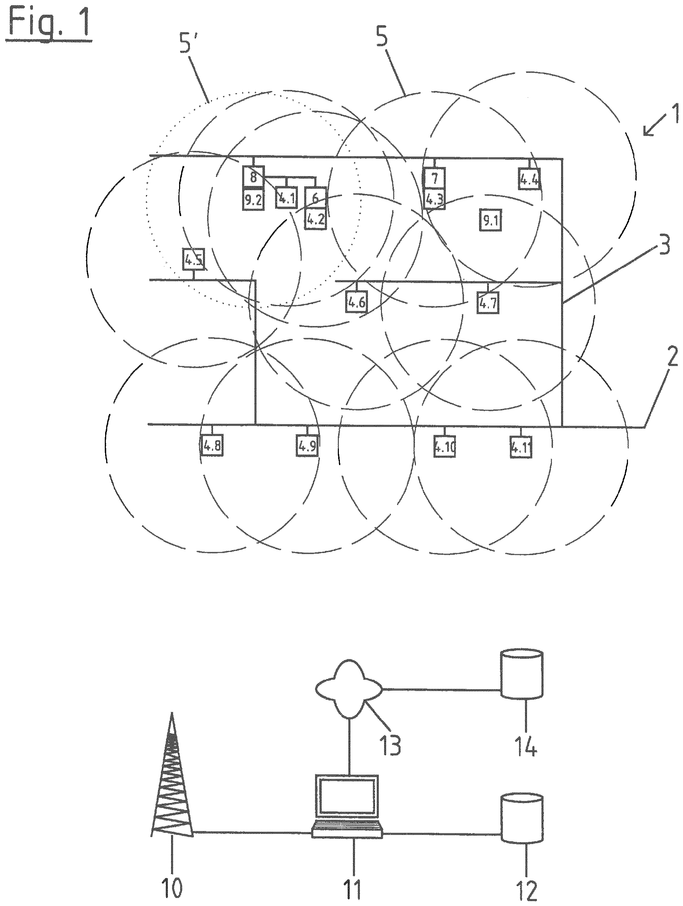

In Figur 1 ist schematisch ein elektrisches Verteilnetz 1 dargestellt, welches am Anbindungspunkt 2 mit einem (nicht dargestellten) vorgelagerten Netz verbunden ist und die von dort kommende elektrische Leitung über verzweigte Leitungsstränge 3 verteilt.

An dem Verteilnetz 1 sind eine Vielzahl von Geräten 4.1 bis 4.11 angeschlossen, die im aktiven Zustand jeweils ein von einer der später noch erläuterten Empfangseinheiten 9.1, 9.2 identifizierbares und einem Gerät 4.1-4.11 eindeutig zuordenbares Funksignal abgeben. Im dargestellten Beispiel handelt es sich bei den Funksignalen ausschließlich um WLAN-Signale. Die Reichweite des jeweiligen Funksignals ist durch die gestrichelten Kreise 5 um die jeweiligen Geräte 4.1-4.11 angedeutet. Das Gerät 4.2 verfügt über eine unterbrechungsfreie Stromversorgung 6, sodass es selbst bei Wegfall der Stromversorgung noch weiter betrieben werden kann. Das Gerät 4.3 ist über eine Zeitschaltuhr 7 mit dem Verteilnetz 1 verbunden und nur in den Zeiten von 9:00 bis 17:00 Uhr aktiv.

Im Bereich des Verteilnetzes 1 sind in Figur 1 beispielhaft weiterhin zwei Empfangseinheiten 9.1, 9.2 eingezeichnet. Bei diesen Empfangseinheiten 9.1, 9.2 handelt es sich um solche, die zum Empfang der von den Geräten 4.1-4.11 im aktiven Zustand ausgesendeten Funksignale ausgebildet sind und außerdem über ein Positionsbestimmungsmodul (nicht dargestellt) zur Bestimmung der Position der jeweiligen Empfangseinheiten 9.1, 9.2 verfügen. Die Empfangseinheiten 9.1, 9.2 verfügen weiterhin über ein Kommunikationsmodul, sodass Daten betreffend die Position der Empfangseinheit 9.1, 9.2 und der von der jeweiligen Empfangseinheit 9.1, 9.2 empfangenen Funksignale über einen durch einen Mobilfunkmast 10 angedeutetes Mobilfunknetz an einen Rechner 11 übertragen werden können. Der Rechner 11 hat weiterhin Zugriff auf eine Datenbank 12, sowie auf das Internet 13 und damit verbundene weitere Datenquellen, nämlich ein Verzeichnis 14 georteter WLAN-Geräte.

Bei dem in Figur 1 dargestellten störungsfreien Verteilnetz 1 wird die erste Stufe des erfindungsgemäßen zweistufigen Verfahrens ausgeführt.

Die Empfangseinheit 9.1 ist eine stationäre Relaisstation des dem Netzbetreibers und dient der Bündelung von Informationen zu netzbetreibereigenen Geräten in der Umgebung der Empfangseinheit, bevor die Informationen gebündelt an eine Leitstelle übermittelt werden. Die Position der Empfangseinheit 9.1 wurde bei der Errichtung der Empfangseinheit 9.1 per GPS ermittelt und in einem Speicher der Empfangseinheit 9.1 selbst hinterlegt. Zur Ermittlung der Position der Empfangseinheit 9.1 wird auf den Speicher zurückgegriffen. Außerdem werden sämtliche Funksignale, die von der Empfangseinheit 9.1 empfangen werden und sich einem der Geräte 4.1-4.11 zuordnen lassen, registriert. Für die dargestellte Position der Empfangseinheit 9.1 sind dies die Geräte 4.3, 4.4 und 4.7, wobei Gerät 4.3 aufgrund der Zeitschaltuhr 7 nur registriert werden kann, wenn die Erfassung im Zeitraum zwischen 9:00 und 17:00 Uhr erfolgt. Die Positionsinformationen der Empfangseinheit 9.1 sowie die Informationen über die von ihr empfangenen Funksignale wird über das Mobilfunknetz an den Rechner 11 übermittelt. Der Rechner 11 ermittelt anhand der Informationen zu den Funksignalen, wie bspw. MAC-Adressen und/oder SSIDs, die sich regelmäßig aus WLAN-Funksignalen gewinnen lassen, über das Verzeichnis 14 georteter WLAN-Geräte die Position der Geräte 4.3, 4.4 und 4.7. Diese Information zu den Geräten 4.3, 4.4 und 4.7 werden in der Datenbank 12 abgelegt. Sollten sich in der Datenbank 12 bereits Informationen zu den fraglichen Geräten 4.3, 4.4 und 4.7 befinden, werden diese bei Bedarf aktualisiert. Durch mehrmalige Erfassung der Funksignale durch die Empfangseinheit 9.1 lässt sich der Zeitraum, in der das Gerät 4.3 aufgrund der Zeitschaltuhr 7 nur aktiv ist, eingrenzen und ebenfalls in der Datenbank 12 ablegen.

Die Empfangseinheit 9.2 ist ein Smartphone, welches einem Nutzer zugeordnet ist. Der Nutzer ist als Inhaber des Stromzählers 8 registriert und teilt den Zählerstand des Stromzählers 8 zu Abrechnungszwecken in Form eines mit dem Smartphone gemachten Foto dem Netzbetreiber mit. In dem Moment der Aufnahme werden die von der Empfangseinheit 9.2 empfangenen Funksignale registriert, nämlich die Funksignale der Geräte 4.1, 4.2 und 4.5. Anhand dieser Funksignale erfolgt auch die Positionsbestimmung der Empfangseinheit 9.2 per WLAN-Ortung. Außerdem wird überprüft, für welches der Geräte 4.1, 4.2 und 4.5, von denen Funksignale empfangen werden, in der Empfangseinheit 9.2 Zugangsdaten hinterlegt sind. Im dargestellten Beispiel sind dies die Geräte 4.1 und 4.2.

Diese gewonnenen Informationen werden über das Mobilfunknetz an den Rechner 11 übermittelt, der - wie schon zuvor beschrieben - die Position der Geräte 4.1 und 4.2 mit Hilfe des Verzeichnisses georteter WLAN-Geräte 14 ermittelt. Für das Gerät 4.5 ist im Verzeichnis 14 keine Position hinterlegt, weshalb für das Gerät 4.5 zunächst die Position der Empfangseinheit 9.2 mit einer Positionsungenauigkeit entsprechend der Reichweite der Funksignale (vgl. gestrichelten Kreise 5) angenommen. Der daraus resultierende Positionsbereich ist durch den gepunkteten Kreis 5' angedeutet. Die Informationen werden entsprechend in der Datenbank 12 abgelegt bzw. aktualisiert.

Da in der Empfangseinheit 9.2 Zugangsdaten für die Geräte 4.1 und 4.2 hinterlegt sind, wird in der Datenbank 12 weiterhin vermerkt, dass die Geräte 4.1 und 4.2 mit hoher Wahrscheinlichkeit über den Stromzähler 8 an das Verteilnetz 1 angebunden sind. Außerdem wird in der Datenbank vermerkt, dass das Gerät 4.2 über eine unterbrechungsfreie Stromversorgung 6 verfügt. Diese Information wird aus einer entsprechenden Kennung in dem von dem Gerät 4.2 ausgesendeten Funksignal gewonnen.

Die anhand der Figur 1 dargestellte erste Stufe des erfindungsgemäßen Verfahrens kann beliebig häufig (vorzugsweise mit wechselnder Position der mobilen Empfangseinheit 9.2) wiederholt oder mit zusätzlichen Empfangseinheiten ausgeführt werden, um bspw. auch die Positionen der Geräte 4.8 bis 4.11 zu erfassen. Durch die Wiederholung der ersten Stufe des erfindungsgemäßen Verfahrens werden gleichzeitig auch die bereits erfassten Daten regelmäßig aktualisiert und so die Güte der Daten verbessert.

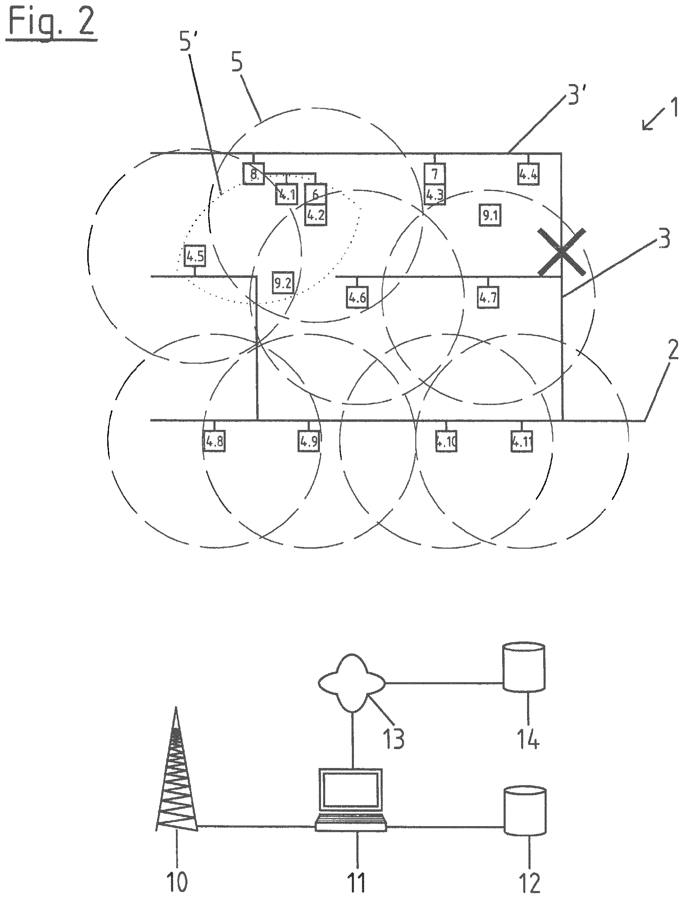

In Figur 2 liegt eine Störung des Verteilnetzes vor, wegen der in dem Leistungsstrang 3' des Versorgungsnetzes 3 kein Strom mehr fließt. In der Folge senden die Geräte 4.1, 4.3 und 4.4 keine Funksignale mehr aus; das Gerät 4.2 sendet aufgrund der unterbrechungsfreien Stromversorgung 6 allerdings noch weiter Funksignale aus, auch wenn es nicht mehr mit Energie über das Verteilnetz 1 versorgt wird.

Die Empfangseinheit 9.1 ermittelt erneut ihre Position aus ihrem Speicher sowie die von ihr empfangenen Funksignale. Aufgrund der Störung im Netz wird jedoch lediglich ein Funksignal des Gerätes 4.7 empfangen. Diese Informationen werden erneut an den Rechner 11 gesandt, der aufgrund der übermittelten Position der Empfangseinheit 9.1 feststellen kann, dass grundsätzlich auch Funksignale des Gerätes 4.4 und - aufgrund der Zeitschaltuhr 7 abhängig von der Tageszeit - des Gerätes 4.3 hätten empfangen werden sollen. Ist dies nicht der Fall, können die Geräte 4.3 und/oder 4.4 als deaktiv angesehen werden.

Auch von der Empfangseinheit 9.1 werden Position - diesmal durch GPS ermittelt und gegenüber der Situation in Figur 1 verändert - sowie die Informationen zu den empfangenen Funksignalen - nämlich von den Geräten 4.2, 4.5 und 4.6 - an den Rechner übermittelt, der daraufhin das Gerät 4.1 als deaktiv ermittelt. Die Erfassung und Übermittlung der entsprechenden Informationen durch die Empfangseinheit 9.2 kann bspw. initiiert werden, wenn der Nutzer über das Smartphone eine Störung des Verteilnetzes 1 beim Netzbetreiber meldet.

Da sie als deaktiv identifiziert wurden, werden die Geräte 4.1, 4.4 und ggf. 4.3 in der Datenbank 12 als wahrscheinlich an einem gemeinsamen Leitungsstrang angebundene Geräte verzeichnet. Zu diesem Zeitpunkt ist in der Datenbank 12 allerdings noch keine Information darüber enthalten, um welchen Leistungsstrang es sich dabei tatsächlich handelt.

Die entsprechende Information, dass die Geräte 4.1, 4.4 und 4.3 tatsächlich am Leitungsstrang 3' hängen ergibt sich erst im Nachhinein, nämlich nach Beheben der Störung. Sobald die Störung behoben ist, können die Funksignale der fraglichen Geräte wieder empfangen werden, wodurch bestätigt wird, dass die Geräte 4.1, 4.4 und 4.3 höchstwahrscheinlich aufgrund der Störung inaktiv waren. Da der Ort der Störung spätestens durch ihr Beheben genau bekannt ist, lässt sich aus den Planungs- und Dokumentationsunterlagen des Leitungsverlaufs des Verteilnetzes 1 ermitteln, dass diese Geräte an dem Leitungsstrang 3' angeschlossen sind.

Die von der Empfangseinheit 9.2 in Figur 2 empfangenen Funksignale können noch zur Aktualisierung bzw. Verifizierung der Informationen in der Datenbank 12 genutzt werden. So kann für das Gerät 4.5 erneut festgestellt werden, dass es sich in einem bestimmten Radius um die Empfangseinheit 9.2 befinden muss. Zusammen mit dem in der ersten Stufe des Verfahrens ermittelten Positionsbereich (vgl. Figur 1), lässt sich nunmehr ein deutlich kleinerer Positionsbereich 5' für das Gerät 4.5 bestimmen. Mit weiteren erfindungsgemäßen Auswertungen der Funksignale kann der Positionsbereich 5' immer weiter verkleinert werden.

Daneben lässt sich durch die von der Empfangseinheit 9.2 empfangenen Funksignale verifizieren, dass das Gerät 4.2 tatsächlich über eine unterbrechungsfreie Stromversorgung 6 verfügt. Bereits in der ersten Stufe des Verfahrens wurde festgestellt, dass die Geräte 4.1 und 4.2 mit hoher Wahrscheinlichkeit über denselben Netzanschlusspunkt bzw. Stromzähler 8 mit dem Versorgungsnetz 1 verbunden sind. Wird nun über die Empfangseinheit 9.2 festgestellt, dass lediglich das Gerät 4.2 noch Funksingale aussendet, während das Gerät 4.1 aufgrund einer Störung im Verteilnetz 1 nicht mehr sendet, wird das Vorhandensein einer unterbrechungsfreien Stromversorgung 6 für das Gerät 4.2 bestätigt.

## Patentansprüche

1. Zweistufiges Verfahren zum Aufbau und zur Aktualisierung einer Datenbank (12) zur Abbildung der Netztopologie eines elektrischen Verteilnetzes (1) basierend auf Positionsinformationen umfassend Angaben zur geographischen Position von an dem Verteilnetz (1) angeschlossenen Geräten (4.1-4.11), die von einem mobilen Endgerät als Empfangseinheit (9.1, 9.2) identifizierbare und dem jeweiligen Gerät (4.1-4.11) zuordenbare Funksignale aussenden, mit den bei einem störungsfreien Verteilnetz (1) auszuführenden Schritten:
a) Bestimmen der Position der Empfangseinheit (9.1, 9.2) durch ein Positionsbestimmungsmodul der Empfangseinheit (9.1, 9.2) und Ermitteln der aktiven, in der Nähe zur Empfangseinheit (9.1, 9.2) befindlichen Geräte (4.1-4.11) anhand der von diesen Geräten (4.1-4.11) ausgesendeten identifizierbaren und dem jeweiligen Gerät (4.1-4.11) zuordenbaren Funksignalen;
b) Bestimmen der Position der Geräte (4.1-4.11), deren Funksignale empfangen wurden; und
c) Ablegen der Identifikationsmerkmale und der Position der Geräte (4.1-4.11) in der Datenbank (12) als neuen Datensatz oder als Aktualisierung eines bestehenden Datensatzes;
sowie den im Falle einer Störung im Verteilnetz (1) auszuführenden Schritten:
d) Bestimmen der Position der Empfangseinheit (9.1, 9.2) durch ein Positionsbestimmungsmodul der Empfangseinheit (9.1, 9.2) und Ermitteln der aktiven, in der Nähe zur Empfangseinheit (9.1, 9.2) befindlichen Geräte (4.1-4.11) anhand der von diesen Geräten (4.1-4.11) ausgesendeten identifizierbaren und dem jeweiligen Gerät (4.1-4.11) zuordenbaren Funksignalen;
e) Ermitteln der deaktiven Geräte (4.1-4.11) in der Nähe der Empfangseinheit (9.1, 9.2) durch Abgleich der bei einer Störung im Verteilnetz ermittelten aktiven Geräte (4.1-4.11) mit den zuvor bei einem störungsfreien Verteilnetz ermittelten, in der Nähe der Empfangseinheit (9.1, 9.2) befindlichen Geräte (4.1-4.11); und
f) Markieren oder Aktualisieren einer bereits bestehenden Markierung der deaktiven Geräte (4.1-4.11) in der Datenbank (12) als mit hoher Wahrscheinlichkeit zu einem Leistungsstrang (3') gehörig.

2. Verfahren nach Anspruch 1,
**dadurch gekennzeichnet, dass**
das Bestimmen der Position der Geräte (4.1-4.11), deren Funksignale empfangen wurden, anhand bereits bestehender Verzeichnisse (14) von Ortsangaben für entsprechende Geräte (4.1-4.11), anhand von Informationen über die Position aus den Funksignalen selbst und/oder ausgehend von der Position der Empfangseinheit (9.1, 9.2) erfolgt.

3. Verfahren nach Anspruch 1 oder 2,
**dadurch gekennzeichnet, dass**
die Positionsinformationen vorzugsweise als Positionsbereiche (5') hinterlegt werden.

4. Verfahren nach einem der vorhergehenden Ansprüche,
**dadurch gekennzeichnet, dass**
in der Datenbank für wenigstens ein Gerät (4.1, 4.2) Informationen über den wahrscheinlichen Netzanschlusspunkt, über den das jeweilige Gerät (4.1, 4.2) mit Energie versorgt wird, erfasst wird.

5. Verfahren nach einem der vorhergehenden Ansprüche,
**dadurch gekennzeichnet, dass**
in der Datenbank (12) für wenigstens ein Gerät (4.1, 4.2, 4.3, 4.4) Informationen über den wahrscheinlichen Leitungsstrang (3'), über den das jeweilige Gerät (4.1, 4.2, 4.3, 4.4) mit Energie versorgt wird, erfasst wird, wobei die Information durch Abgleich der Position der Geräte (4.1, 4.2, 4.3, 4.4) mit dem Leitungsverlaufs des Verteilnetzes (1) und/oder durch Abgleich der Position einer Netzstörung und der davon betroffenen Leitungsstränge (3') und der Veränderung des Aktivitätsstatus des Gerätes (4.1, 4.2, 4.3, 4.4) in Abhängigkeit von der Störung ermittelt wird.

6. Verfahren nach einem der vorhergehenden Ansprüche,
**dadurch gekennzeichnet, dass**
die Datenbank (12) Informationen über die zeitabhängige Aktivierung und Deaktivierung von wenigstens einem Teil der an dem Verteilnetz (1) angeschlossenen Geräte (4.3) und/oder Informationen darüber, ob an das Verteilnetz (1) angeschlossene Geräte (4.2) über eine unterbrechungsfreie Stromversorgung (6) verfügen, umfassen.

7. Verfahren nach einem der vorhergehenden Ansprüche,
**dadurch gekennzeichnet, dass**
die Empfangseinheit (9.2) ein Smartphone oder ein Tablet ist.

8. Verfahren nach einem der vorhergehenden Ansprüche,
**dadurch gekennzeichnet, dass**
das Positionsbestimmungsmodul zur Bestimmung der Position der Empfangseinheit (9.1, 9.2) über Satellitennavigationssignale, über eine Auswertung der von der Empfangseinheit identifizierbaren und einem Gerät zuordenbaren Funksignalen und/oder durch Abruf einer in einem Speicher hinterlegten Position ausgebildet ist.

9. Verfahren nach einem der vorhergehenden Ansprüche,
**dadurch gekennzeichnet, dass**
die von der Empfangseinheit (9.1, 9.2) identifizierbaren und einem Gerät zuordenbare Funksignale WLAN-, Bluetooth-, Zigbee-, Z-Wave- und/oder EnOcean-Signale sind.

10. Verwendung einer mit einem Verfahren gemäß einem der vorhergehenden Ansprüche aufgebauten oder aktualisierten Datenbank (12) zur Lokalisierung von Störungen in einem Verteilnetz (1) mit Hilfe eines mobilen Endgerätes als Empfangseinheit (9.1, 9.2) umfassend ein Positionsbestimmungsmodul, mit den Schritten:
a) Ermitteln der aktiven, in der Nähe zur Empfangseinheit (9.1, 9.2) befindlichen Geräte (4.1-4.11) anhand der von diesen Geräten (4.1-4.11) ausgesendeten identifizierbaren und dem jeweiligen Gerät (4.1-4.11) zuordenbaren Funksignale;
b) Bestimmen der Position der Empfangseinheit (9.1, 9.2) durch das Positionsbestimmungsmodul;
c) Ermitteln von in der Nähe der Empfangseinheit (9.1, 9.2) befindlichen Geräte (4.1-4.11) aus der Datenbank auf Basis der ermittelten Position der Empfangseinheit (9.1, 9.2);
d) Ermitteln der deaktiven Geräte (4.1-4.11) in der Nähe der Empfangseinheit (9.1, 9.2) durch Abgleich der ermittelten aktiven Geräte (4.1-4.11) mit den ermittelten in der Nähe der Empfangseinheit (9.1, 9.2) befindlichen Geräte (4.1-4.11); und
e) Eingrenzen der Störung im Verteilnetz durch Auswertung der Positionsinformationen umfassend Angaben zur geographischen Position der ermittelten aktiven und deaktiven Geräte (4.1-4.11).

## Claims

1. Two-stage method for setting up and updating a database (12) for representing the network topology of an electrical distribution network (1) on the basis of position information comprising details of the geographical position of devices (4.1-4.11) which are connected to the distribution network (1) and emit radio signals which can be identified by a mobile terminal as a receiving unit (9.1, 9.2) and can be assigned to the respective device (4.1-4.11), having the steps to be carried out in the case of a fault-free distribution network (1):
a) determining the position of the receiving unit (9.1, 9.2) by means of a position determination module of the receiving unit (9.1, 9.2) and determining the active devices (4.1-4.11) in the vicinity of the receiving unit (9.1, 9.2) on the basis of the identifiable radio signals which are emitted by these devices (4.1-4.11) and can be assigned to the respective device (4.1-4.11);
b) determining the position of the devices (4.1-4.11), the radio signals of which have been received; and
c) storing the identification features and the position of the devices (4.1-4.11) in the database (12) as a new data record or as an update of an existing data record;
and having the following steps to be carried out in the event of a fault in the distribution network (1) :
d) determining the position of the receiving unit (9.1, 9.2) by means of a position determination module of the receiving unit (9.1, 9.2) and determining the active devices (4.1-4.11) in the vicinity of the receiving unit (9.1, 9.2) on the basis of the identifiable radio signals which are emitted by these devices (4.1-4.11) and can be assigned to the respective device (4.1-4.11);
e) determining the inactive devices (4.1-4.11) in the vicinity of the receiving unit (9.1, 9.2) by comparing the active devices (4.1-4.11) determined in the event of a fault in the distribution network with the devices (4.1-4.11) in the vicinity of the receiving unit (9.1, 9.2) which were previously determined in the case of a fault-free distribution network; and
f) marking or updating an already existing marking of the inactive devices (4.1-4.11) in the database (12) as belonging, with a high degree of probability, to a power section (3').

2. Method according to Claim 1,
**characterized in that**
the position of the devices (4.1-4.11), the radio signals of which have been received, is determined on the basis of already existing directories (14) of location information for corresponding devices (4.1-4.11), on the basis of information relating to the position from the radio signals themselves and/or on the basis of the position of the receiving unit (9.1, 9.2).

3. Method according to Claim 1 or 2,
**characterized in that**
the position information is preferably stored as position ranges (5').

4. Method according to one of the preceding claims,
**characterized in that**
the database captures, for at least one device (4.1, 4.2), information relating to the probable network connection point, via which the respective device (4.1, 4.2) is supplied with energy.

5. Method according to one of the preceding claims,
**characterized in that**
the database (12) captures, for at least one device (4.1, 4.2, 4.3, 4.4), information relating to the probable line section (3'), via which the respective device (4.1, 4.2, 4.3, 4.4) is supplied with energy, wherein the information is determined by comparing the position of the devices (4.1, 4.2, 4.3, 4.4) with the line course of the distribution network (1) and/or by comparing the position of a network fault and the line sections (3') affected thereby and the change in the activity status of the device (4.1, 4.2, 4.3, 4.4) on the basis of the fault.

6. Method according to one of the preceding claims,
**characterized in that**
the database (12) comprises information relating to the time-dependent activation and deactivation of at least some of the devices (4.3) connected to the distribution network (1) and/or information relating to whether devices (4.2) connected to the distribution network (1) have an uninterruptible power supply (6).

7. Method according to one of the preceding claims,
**characterized in that**
the receiving unit (9.2) is a smartphone or a tablet.

8. Method according to one of the preceding claims,
**characterized in that**
the position determination module is designed to determine the position of the receiving unit (9.1, 9.2) using satellite navigation signals, by evaluating the radio signals which can be identified by the receiving unit and can be assigned to a device and/or by retrieving a position stored in a memory.

9. Method according to one of the preceding claims,
**characterized in that**
the radio signals which can be identified by the receiving unit (9.1, 9.2) and can be assigned to a device are WLAN, Bluetooth, Zigbee, Z-Wave and/or EnOcean signals.

10. Use of a database (12) set up or updated using a method according to one of the preceding claims to locate faults in a distribution network (1) with the aid of a mobile terminal as a receiving unit (9.1, 9.2) comprising a position determination module, having the steps:
a) determining the active devices (4.1-4.11) in the vicinity of the receiving unit (9.1, 9.2) on the basis of the identifiable radio signals which are emitted by these devices (4.1-4.11) and can be assigned to the respective device (4.1-4.11);
b) determining the position of the receiving unit (9.1, 9.2) by means of the position determination module;
c) determining devices (4.1-4.11) in the vicinity of the receiving unit (9.1, 9.2) from the database on the basis of the determined position of the receiving unit (9.1, 9.2);
d) determining the inactive devices (4.1-4.11) in the vicinity of the receiving unit (9.1, 9.2) by comparing the determined active devices (4.1-4.11) with the determined devices (4.1-4.11) in the vicinity of the receiving unit (9.1, 9.2); and
e) narrowing down the fault in the distribution network by evaluating the position information comprising details of the geographical position of the determined active and inactive devices (4.1-4.11).

## Revendications

1. Procédé à deux niveaux de réalisation et d'actualisation d'une base de données (12) destinée à représenter la topologie d'un réseau de distribution électrique (1) en se basant sur des informations de position comprenant des données sur la position géographique d'appareils (4.1-4.11) raccordés au réseau de distribution (1), lesquels émettent des signaux radio identifiables par un terminal mobile en tant qu'unité de réception (9.1, 9.2) et assignables à l'appareil respectif (4.1-4.11), doté des étapes à mettre en oeuvre lorsque le réseau de distribution (1) est sans perturbations :
a) localisation de l'unité de réception (9.1, 9.2) par un module de localisation de l'unité de réception (9.1, 9.2) et détermination des appareils (4.1-4.11) actifs se trouvant à proximité de l'unité de réception (9.1, 9.2) identifiables à l'aide des signaux radio émis par ces appareils (4.1-4.11) et assignables à l'appareil respectif (4.1-4.11) ;
b) localisation des appareils (4.1-4.11) dont les signaux radio ont été reçus ; et
c) dépôt des caractéristiques d'identifications et de la position des appareils (4.1-4.11) dans la base de données (12) comme nouveau bloc de données ou comme actualisation d'un bloc de données existant ;
ainsi que des étapes à mettre en oeuvre en cas de perturbation dans le réseau de distribution (1) :
d) localisation de l'unité de réception (9.1, 9.2) par un module de localisation de l'unité de réception (9.1, 9.2) et détermination des appareils (4.1-4.11) actifs se trouvant à proximité de l'unité de réception (9.1, 9.2) identifiables à l'aide des signaux radio émis par ces appareils (4.1-4.11) et assignables à l'appareil respectif (4.1-4.11) ;
e) détermination des appareils (4.1-4.11) inactifs se trouvant à proximité de l'unité de réception (9.1, 9.2) par comparaison des appareils (4.1-4.11) actifs déterminés lors d'une perturbation dans le réseau de distribution avec les appareils (4.1-4.11) actifs se trouvant à proximité de l'unité de réception (9.1, 9.2) déterminés lorsque le réseau de distribution était sans perturbation ; et
f) marquage ou actualisation d'un marquage déjà existant des appareils (4.1-4.11) inactifs dans la base de données (12) comme appartenant avec une probabilité élevée à un tronçon de puissance (3').

2. Procédé selon la revendication 1, **caractérisé en ce que** la localisation des appareils (4.1-4.11) dont les signaux radio sont reçus, s'effectue d'elle-même et/ou à partir de la position de l'unité de réception (9.1, 9.2), à l'aide de registres (14) déjà existants de données de localisation pour les appareils (4.1-4.11) correspondants, à l'aide d'informations sur la position issues des signaux radio.

3. Procédé selon la revendication 1 ou 2, **caractérisé en ce que** les informations sur la position sont entrées de préférence comme intervalles de positions (5').

4. Procédé selon l'une des revendications ci-dessus, **caractérisé en ce que** pour au moins un appareil (4.1, 4.2), des informations sur le point probable de raccordement au réseau par le biais duquel l'appareil respectif (4.1, 4.2) est alimenté en énergie sont saisies dans la base de données.

5. Procédé selon l'une des revendications ci-dessus, **caractérisé en ce que** pour au moins un appareil (4.1, 4.2, 4.3, 4.4), des informations sur le tronçon de ligne probable (3') par le biais de laquelle l'appareil respectif (4.1, 4.2, 4.3, 4.4) est alimenté en énergie sont saisies dans la base de données (12), dans lequel l'information est déterminée par comparaison de la position de l'appareil (4.1, 4.2, 4.3, 4.4) avec le circuit du réseau de distribution (1) et/ou par comparaison de la position d'une perturbation réseau et du tronçon de ligne (3') concerné et de la modification du statut d'activité de l'appareil (4.1, 4.2, 4.3, 4.4) en fonction de la perturbation.

6. Procédé selon l'une des revendications ci-dessus, **caractérisé en ce que** la base de données (12) comprend des informations sur l'activation et la désactivation d'au moins une partie des appareils (4.3) raccordés au réseau de distribution (1) en fonction du temps et/ou des informations sur la fourniture ou non d'une alimentation électrique sans coupure (6) aux appareils (4.2) raccordés au réseau de distribution (1).

7. Procédé selon l'une des revendications ci-dessus, **caractérisé en ce que** l'unité de réception (9.2) est un smartphone ou une tablette.

8. Procédé selon l'une des revendications ci-dessus, **caractérisé en ce que** le module de localisation est conçu pour la localisation de l'unité de réception (9.1, 9.2) par le biais de signaux de navigation par satellite, par le biais d'une évaluation des signaux radio identifiables par l'unité de réception et assignables à un appareil et/ou par récupération d'une position entrée dans une mémoire.

9. Procédé selon l'une des revendications ci-dessus, **caractérisé en ce que** les signaux radio identifiables par l'unité de réception (9.1, 9.2) et assignables à un appareil sont des signaux WLAN, Bluetooth, Zigbee, Z-Wave et/ou EnOcean.

10. Utilisation d'une base de données (12) réalisée ou actualisée avec un procédé selon l'une des revendications ci-dessus pour localiser des perturbations dans un réseau de distribution (1) à l'aide d'un terminal mobile en tant qu'unité de réception (9.1, 9.2), comprenant un module de localisation, avec les étapes :
a) détermination des appareils (4.1-4.11) actifs se trouvant à proximité de l'unité de réception (9.1, 9.2) identifiables à l'aide des signaux radio émis par ces appareils (4.1-4.11) et assignables à l'appareil respectif (4.1-4.11) ;
b) localisation de l'unité de réception (9.1, 9.2) par le module de localisation de l'unité de réception ;
c) détermination des appareils (4.1-4.11) se trouvant à proximité de l'unité de réception (9.1, 9.2) à partir de la base de données en se basant sur la position déterminée de l'unité de réception (9.1, 9.2) ;
d) détermination des appareils (4.1-4.11) inactifs se trouvant à proximité de l'unité de réception (9.1, 9.2) par comparaison des appareils (4.1-4.11) actifs déterminés avec les appareils (4.1-4.11) actifs se trouvant à proximité de l'unité de réception (9.1, 9.2) ; et
e) circonscription de la perturbation dans le réseau par évaluation des données comprenant des informations de positions sur la position géographique des appareils déterminés actifs et inactifs (4.1-4.11).
